# EUROPEAN PATENT SPECIFICATION

(11) **EP 4 375 687 B1**
(45) Date of publication and mention of the grant of the patent: **15.04.2026**
(21) Application number: 23181952.5
(22) Date of filing: 28.06.2023
(51) Int. Cl.: G01R 31/385, G01R 31/52, G01R 1/067, G01R 31/389

(54) **APPARATUS FOR INSPECTING INSULATION OF CYLINDRICAL BATTERY**
VORRICHTUNG ZUR INSPEKTION DER ISOLIERUNG EINER ZYLINDRISCHEN BATTERIE
APPAREIL D'INSPECTION DE L'ISOLATION D'UNE BATTERIE CYLINDRIQUE

(30) Priority: 22.11.2022 KR 20220157727
(43) Date of publication of application: 29.05.2024
(73) Proprietor: Sejong Technology Co.,Ltd, Chungcheongnam-do 31418 (KR)
(72) Inventor: KIM, Deok Ho, 31089 Cheonan-si (KR); SEO, Kyung Yong, 31110 Cheonan-si (KR); KIM, Jin Saeng, 31085 Cheonan-si (KR)
(74) Representative: Dr. Gassner & Partner mbB

(56) References cited:
- CN-A- 107 703 455
- CN-A- 111 650 522
- DE-A1- 102013 203 406
- KR-B1- 101 923 679
- US-A1- 2012 019 256

## Description

### BACKGROUND OF THE INVENTION

### 1. Field of the Invention

The present invention relates to an apparatus for inspecting insulation of a cylindrical battery, and more particularly, to an apparatus for inspecting insulation of a cylindrical battery, capable of inspecting an insulation state of the cylindrical battery having an outer circumferential surface attached with an insulating tape.

### 2. Description of the Related Art

A secondary battery refers to a battery including at least one electrochemical cell that may be charged and discharged. Secondary batteries are produced in various shapes and sizes, including button cells connected to stabilize a distribution network and megawatt systems, in which various combinations of electrode materials and electrolytes, including lead-acid, nickel-cadmium (NiCd), nickel-hydrogen (NiMH), lithium-ion (Li-ion), lithium-ion polymer (Li-ion polymer), and the like, are used.

Secondary batteries are manufactured in various shapes. Due to influences of a mounting space, a structure, a standard, mass productivity, and the like, the secondary batteries may be manufactured in a circular type having a cylindrical shape, a polygonal type having a rectangular parallelepiped shape, a pouch type having a pocket shape, and the like.

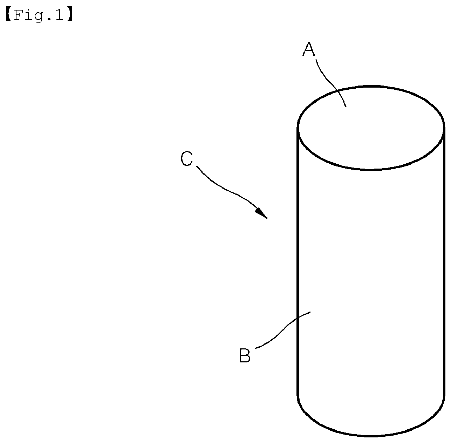

FIG. 1 shows a general cylindrical (circular) battery C. The cylindrical battery C has a top surface A on which a terminal part is provided, and an outer circumferential surface B to which an insulating tape for preventing an electric leakage is attached.

In this case, ideally, the outer circumferential surface of the cylindrical battery has to be insulated by the insulating tape. When a current is conducted through the outer circumferential surface B, the insulating tape may be defective, or taping may be defective, so that the insulating tape may be reattached after being removed, or the cylindrical battery may be determined as a defective product.

If an electric leakage occurs on the outer circumferential surface of the cylindrical battery, ignition or explosion may occur in a battery pack including a plurality of cylindrical batteries.

Therefore, there is a demand to develop an apparatus for inspecting insulation of a cylindrical battery, capable of inspecting an electric leakage of an outer circumferential surface of the cylindrical battery. CN 107 703 455 discloses an apparatus for inspecting a cylindrical battery comprising a main frame and at least one conductive member.

### [Documents of Related Art]

### [Patent Documents]

Korean Patent Registration No. 10-1261756 (Sebang Battery Co., Ltd.), April 30, 2013.

### SUMMARY OF THE INVENTION

An object of the present invention is to provide an apparatus for inspecting insulation of a cylindrical battery, capable of inspecting an insulation state of the cylindrical battery having an outer circumferential surface attached with an insulating tape.

To achieve the object described above, an apparatus according to claim 1 is provided. The apparatus for inspecting insulation of a cylindrical battery, the apparatus including: a main frame forming an exterior; a lift module provided on the main frame, and on which the cylindrical battery having an outer circumferential surface attached with an insulating tape is seated; a probe module provided on the main frame, and making contact with a top surface of the cylindrical battery to apply a current to the cylindrical battery; and an outer circumferential surface module provided on the main frame, making contact with the outer circumferential surface of the cylindrical battery, and configured to detect a current conducted through the outer circumferential surface of the cylindrical battery when the probe module applies the current to the cylindrical battery.

The outer circumferential surface module includes: an outer circumferential surface frame fixed to the main frame; an outer circumferential surface bracket configured to move forward and rearward with respect to the outer circumferential surface frame; an outer circumferential surface moving unit provided on the outer circumferential surface frame, and configured to move the outer circumferential surface bracket forward and rearward; an outer circumferential surface guide provided on the outer circumferential surface frame, and configured to guide the outer circumferential surface bracket when the outer circumferential surface bracket moves forward and rearward; an outer circumferential surface plate to which an electric leakage detector for detecting an electric leakage is coupled; an insulating resin provided between the outer circumferential surface bracket and the outer circumferential surface plate to insulate the outer circumferential surface bracket from the outer circumferential surface plate; and a conductive member coupled to the outer circumferential surface plate, and making contact with the outer circumferential surface of the cylindrical battery. Further the conductive member includes a concave-convex part that protrudes so as to be coupled to the outer circumferential surface plate, and the conductive member may be detachably attached to the outer circumferential surface plate by the concave-convex part.

In addition, the conductive member may allow the current, which is conducted through the outer circumferential surface of the cylindrical battery, to be conducted through the outer circumferential surface plate.

In addition, the conductive member may include a seating part that is curved to correspond to the outer circumferential surface of the cylindrical battery.

In addition, the conductive member may be formed of an elastic material.

In addition, the conductive member may include a concavo-convex part that protrudes so as to be coupled to the outer circumferential surface plate.

In addition, the lift module may include: a seating socket on which a bottom surface of the cylindrical battery is seated; a lift cylinder provided on the main frame, coupled to the seating socket, and configured to lift and lower the seating socket in a vertical direction; and a lift motor coupled to the lift cylinder, and configured to lift and lower the lift cylinder in the vertical direction.

In addition, the probe module may include: a probe pin making contact with the top surface of the cylindrical battery to apply the current to the top surface of the cylindrical battery; a horizontal moving unit coupled to the probe pin, and configured to move the probe pin in a horizontal direction; and a vertical moving unit provided on the main frame, coupled to the horizontal moving unit, and configured to move the horizontal moving unit in a vertical direction.

In addition, the horizontal moving unit may include: a probe frame configured to move in the horizontal direction, and having an end portion to which the probe pin is coupled; a horizontal cylinder coupled to the probe frame to move the probe frame in the horizontal direction; and a horizontal frame to which the horizontal cylinder is coupled, and having a lower portion to which the vertical moving unit is coupled.

In addition, the vertical moving unit may include: a vertical cylinder coupled to the horizontal moving unit to move the horizontal moving unit in the vertical direction; and a vertical frame coupled to the main frame, and to which the vertical cylinder is coupled.

According to the apparatus for inspecting the insulation of the cylindrical battery of one embodiment of the present invention, when the probe module (30) applies the current to the cylindrical battery (C), the outer circumferential surface module (40) can make contact with the outer circumferential surface (B) of the cylindrical battery (C) to inspect an insulation state of the outer circumferential surface (B) of the cylindrical battery (C).

### BRIEF DESCRIPTION OF THE DRAWINGS

FIG. 1 is a view showing a general cylindrical battery.
FIG. 2 is a perspective view showing an apparatus for inspecting insulation of a cylindrical battery according to one embodiment of the present invention.
FIG. 3 is a front view showing the apparatus for inspecting the insulation of the cylindrical battery according to one embodiment of the present invention.
FIG. 4 is a plan view showing the apparatus for inspecting the insulation of the cylindrical battery according to one embodiment of the present invention.
FIG. 5 is a perspective view showing an outer circumferential surface module 40 according to one embodiment of the present invention.
FIG. 6 is a plan view showing a conductive member 47 according to one embodiment of the present invention.
FIG. 7 is a perspective view showing a lift module 20 according to one embodiment of the present invention.
FIG. 8 is a perspective view showing a probe module 30 according to one embodiment of the present invention.
FIG. 9 is a view showing an operation of the lift module 20 according to one embodiment of the present invention.
FIG. 10 is a view showing operations of the outer circumferential surface module 40 and the probe module 30 according to one embodiment of the present invention.
FIG. 11 is an enlarged view showing the conductive member 47 according to one embodiment of the present invention.

### DETAILED DESCRIPTION OF THE INVENTION

Advantages and features of the present invention and methods of accomplishing the same will be understood more readily with reference to the following detailed description of embodiments taken in conjunction with the accompanying drawings. However, the present invention may be embodied in various other forms without being limited to the embodiments disclosed below. Merely, the embodiments are provided so that the invention of the present disclosure will be thorough and complete, and will fully convey the scope of the invention to those of ordinary skill in the art to which the present invention pertains. The present invention will only be defined by the scope of the appended claims. Like reference numerals refer to like elements throughout the specification.

Hereinafter, exemplary embodiments of the present invention will be described in detail with reference to the accompanying drawings. Like reference numerals presented in each drawing designate like members.

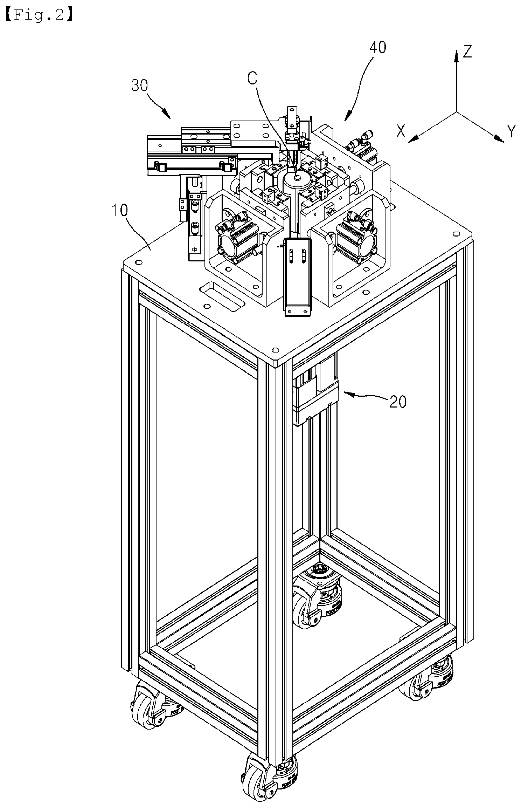

Hereinafter, an apparatus for inspecting insulation of a cylindrical battery according to one embodiment of the present invention will be described with reference to FIGS. 2 to 6.

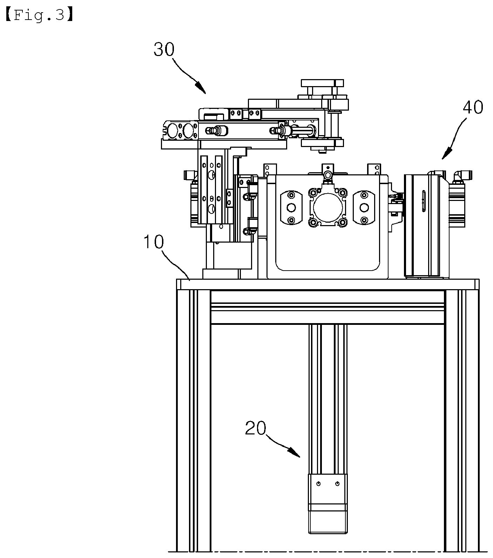

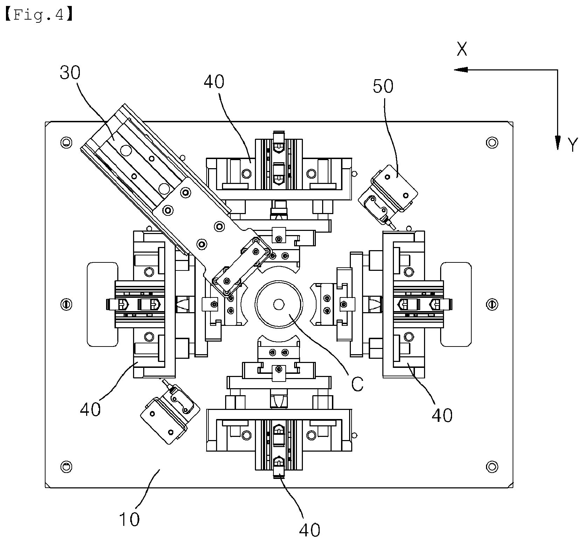

FIG. 2 is a perspective view showing an apparatus for inspecting insulation of a cylindrical battery according to one embodiment of the present invention, FIG. 3 is a front view showing the apparatus for inspecting the insulation of the cylindrical battery according to one embodiment of the present invention, and FIG. 4 is a plan view showing the apparatus for inspecting the insulation of the cylindrical battery according to one embodiment of the present invention.

Referring to FIGS. 2 to 4, according to one embodiment of the present invention, an apparatus for inspecting insulation of a cylindrical battery may include: a main frame 10 forming an exterior; a lift module 20 provided on the main frame 10, and on which the cylindrical battery C having an outer circumferential surface B attached with an insulating tape is seated; a probe module 30 provided on the main frame 10, and making contact with a top surface A of the cylindrical battery C to apply a current to the cylindrical battery C; and an outer circumferential surface module 40 provided on the main frame 10, making contact with the outer circumferential surface B of the cylindrical battery C, and configured to detect a current conducted through the outer circumferential surface B of the cylindrical battery C when the probe module 30 applies the current to the cylindrical battery C.

In FIG. 2, X-axis, Y-axis, and Z-axis directions are defined. In this case, the X-axis and/or Y-axis direction will be defined as a horizontal direction, and the Z-axis direction will be defined as a vertical direction.

The cylindrical battery C may be implemented as a secondary battery. A terminal part may be provided on the top surface A of the cylindrical battery C. The current may be conducted through the terminal part.

The outer circumferential surface B of the cylindrical battery C may be curved. The insulating tape for preventing an electric leakage may be attached to the outer circumferential surface B of the cylindrical battery C.

The main frame 10 may form the exterior. The main frame 10 may be coupled with components that will be described below.

The lift module 20 may be provided on the main frame 10. The cylindrical battery C may be transferred to the lift module 20. The cylindrical battery C having the outer circumferential surface B attached with the insulating tape may be seated on the lift module 20. The lift module 20 may support a bottom surface of the cylindrical battery C.

A laser sensor 50 may be provided on the main frame 10. The laser sensor 50 may sense whether the cylindrical battery C is seated on the lift module 20. The laser sensor 50 may sense whether the cylindrical battery C is seated in a regular position. In this case, the regular position will be defined as a position in which the probe module 30 and the outer circumferential surface module 40, which will be described below, may accurately make contact with the cylindrical battery **C.**

The probe module 30 may be provided on the main frame 10. The probe module 30 may move in the horizontal and vertical directions.

The probe module 30 may make contact with the top surface A of the cylindrical battery C. In this case, the probe module 30 may make contact with the terminal part of the cylindrical battery C.

The probe module 30 may apply the current to the cylindrical battery C. In this case, the probe module 30 may apply the current to the terminal part of the cylindrical battery C. At this point, the outer circumferential surface B of the cylindrical battery C has to be insulated by the insulating tape that is attached to the outer circumferential surface B of the cylindrical battery C.

The outer circumferential surface module 40 may be provided on the main frame 10. The outer circumferential surface module 40 may be provided to face the outer circumferential surface B of the cylindrical battery C.

A plurality of outer circumferential surface modules 40 may be provided. Although four outer circumferential surface modules 40 have been described as being provided in FIGS. 2 to 11, the embodiment is not limited thereto.

The outer circumferential surface module 40 may move in the horizontal direction. The outer circumferential surface module 40 may move in the horizontal direction to make contact with the outer circumferential surface B of the cylindrical battery **C.**

The outer circumferential surface module 40 may detect the current conducted through the outer circumferential surface B of the cylindrical battery **C.** As described above, the insulating tape may be attached to the outer circumferential surface B of the cylindrical battery C so that the outer circumferential surface B of the cylindrical battery C may be insulated from an outside.

If an electric leakage occurs on the outer circumferential surface B of the cylindrical battery **C,** the current may be conducted through the outer circumferential surface module **40.** In this case, an electric leakage detector (not shown) coupled to the outer circumferential surface module 40 may detect the current so as to detect the electric leakage that has occurred on the outer circumferential surface B of the cylindrical battery **C.**

Accordingly, when the probe module 30 applies the current to the cylindrical battery C, the outer circumferential surface module 40 may make contact with the outer circumferential surface B of the cylindrical battery C to inspect an insulation state of the outer circumferential surface B of the cylindrical battery **C.**

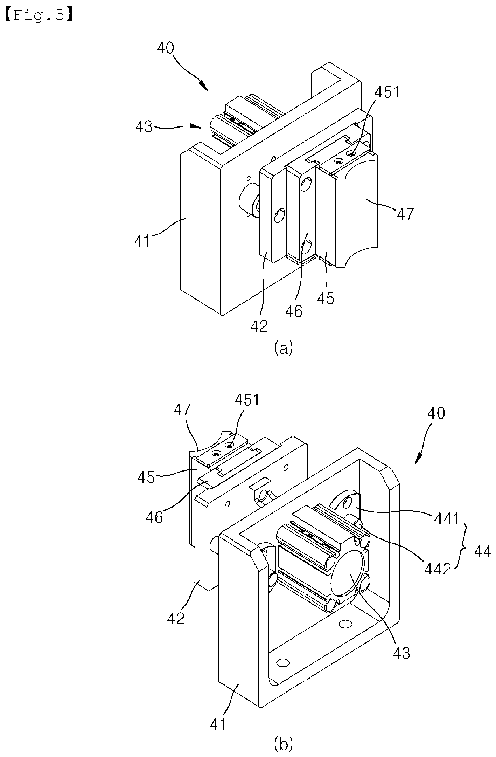

Hereinafter, detailed components of the apparatus for inspecting the insulation of the cylindrical battery according to one embodiment of the present invention will be described in detail with reference to FIGS. 5 to 8.

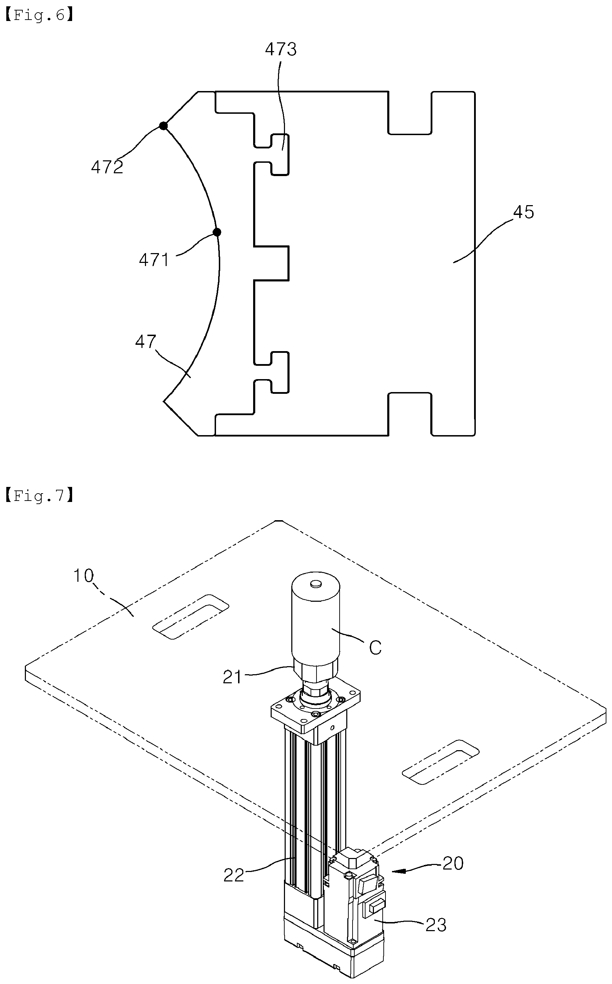

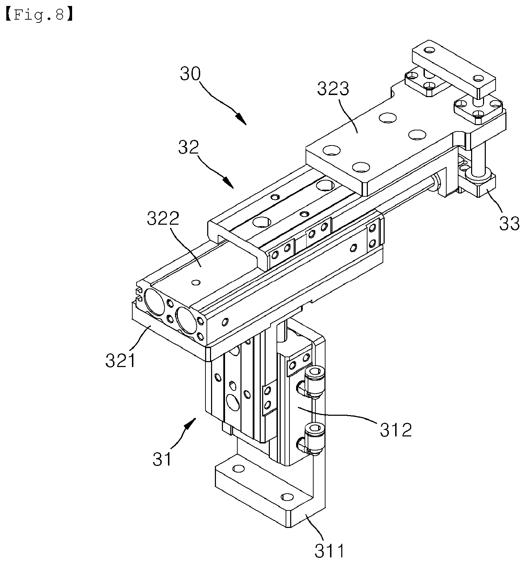

FIG. 5 is a perspective view showing an outer circumferential surface module 40 according to one embodiment of the present invention, FIG. 6 is a plan view showing a conductive member 47 according to one embodiment of the present invention, FIG. 7 is a perspective view showing a lift module 20 according to one embodiment of the present invention, and FIG. 8 is a perspective view showing a probe module 30 according to one embodiment of the present invention.

Referring to FIGS. 5 and 6, according to one embodiment of the present invention, the outer circumferential surface module 40 may include: an outer circumferential surface frame 41 fixed to the main frame 10; an outer circumferential surface bracket 42 configured to move forward and rearward with respect to the outer circumferential surface frame 41; an outer circumferential surface moving unit 43 provided on the outer circumferential surface frame 41, and configured to move the outer circumferential surface bracket 42 forward and rearward; an outer circumferential surface guide 44 provided on the outer circumferential surface frame 41, and configured to guide the outer circumferential surface bracket 42 when the outer circumferential surface bracket 42 moves forward and rearward; an outer circumferential surface plate 45 to which an electric leakage detector for detecting an electric leakage is coupled; an insulating resin 46 provided between the outer circumferential surface bracket 42 and the outer circumferential surface plate 45 to insulate the outer circumferential surface bracket 42 from the outer circumferential surface plate 45; and a conductive member 47 coupled to the outer circumferential surface plate 45, and making contact with the outer circumferential surface B of the cylindrical battery **C.**

The outer circumferential surface frame 41 may be fixed to the main frame 10. The outer circumferential surface frame 41 may be provided perpendicularly to the main frame 10.

The outer circumferential surface bracket 42 may move forward and rearward with respect to the outer circumferential surface frame 41. In this case, the outer circumferential surface bracket 42 may move in the horizontal direction with respect to the outer circumferential surface frame 41.

The outer circumferential surface moving unit 43 may be provided on the outer circumferential surface frame 41. The outer circumferential surface moving unit 43 may be implemented as a servo cylinder. The outer circumferential surface moving unit 43 may move the outer circumferential surface bracket 42 forward and rearward with respect to the outer circumferential surface frame 41.

The outer circumferential surface guide 44 may be provided on the outer circumferential surface frame 41. The outer circumferential surface guide 44 may have one side provided on the outer circumferential surface frame 41 and an opposite side provided on the outer circumferential surface bracket 42. The outer circumferential surface guide 44 may guide the outer circumferential surface bracket 42 so as to allow the outer circumferential surface bracket 42 to stably move in the horizontal direction when the outer circumferential surface bracket 42 moves forward and rearward with respect to the outer circumferential surface frame 41.

In some embodiments, the outer circumferential surface guide 44 may be implemented as an outer circumferential surface bush 441 provided on the outer circumferential surface frame 41, and an outer circumferential surface rod 442 having one end passing through the outer circumferential surface bush 441 and an opposite end fixed to the outer circumferential surface bracket 42.

The outer circumferential surface plate 45 may be spaced apart from the outer circumferential surface bracket 42. The outer circumferential surface plate 45 may move in the horizontal direction.

The outer circumferential surface plate 45 may be implemented by using a material that conducts a current. The electric leakage detector (not shown) for detecting the electric leakage may be coupled to the outer circumferential surface plate 45. In this case, a coupling groove 451 to which the electric leakage detector is coupled may be formed in the outer circumferential surface plate 45. When the current is conducted from the outer circumferential surface B of the cylindrical battery C to the outer circumferential surface plate 45, the electric leakage detector may detect the current conducted to the outer circumferential surface plate 45.

The insulating resin 46 may be provided between the outer circumferential surface bracket 42 and the outer circumferential surface plate 45. The insulating resin 46 may insulate the outer circumferential surface bracket 42 from the outer circumferential surface plate 45. The insulating resin 46 may be variously implemented by using a polymer resin, rubber, or the like. The insulating resin 46 may insulate the outer circumferential surface plate 45 from the outer circumferential surface bracket 42 to prevent the current from leaking through the outer circumferential surface bracket 42. In addition, the insulating resin 46 may prevent a current conducted through the outer circumferential surface bracket 42 from being conducted through the outer circumferential surface plate 45 and detected by the electric leakage detector.

The conductive member 47 may be coupled to the outer circumferential surface plate 45. The conductive member 47 may be formed of a material that conducts a current. The conductive member 47 may be implemented by using an elastically deformable material. In this case, the conductive member 47 may be implemented by using conductive rubber that conducts a current, but the embodiment is not limited thereto.

The conductive member 47 may make contact with the outer circumferential surface B of the cylindrical battery C. The conductive member 47 may be implemented by using an elastic material to make close contact with the outer circumferential surface B of the cylindrical battery C.

As described above, the insulating tape has to be attached to the outer circumferential surface B of the cylindrical battery C to insulate the current. However, the electric leakage may occur on the outer circumferential surface B due to a defect of the insulating tape, defective taping, or the like. In this case, the conductive member 47 may make contact with the outer circumferential surface B of the cylindrical battery C to allow the current, which is conducted through the outer circumferential surface B of the cylindrical battery C, to be conducted through the outer circumferential surface plate 45. Accordingly, the electric leakage detector coupled to the outer circumferential surface plate 45 may detect the electric leakage.

The conductive member 47 may include a seating part 471 that is curved to correspond to the outer circumferential surface B of the cylindrical battery C. The seating part 471 may be recessed so as to be curved. The outer circumferential surface B of the cylindrical battery C may be seated on the seating part 471.

A protruding part 472 may protrude from both end portions of the seating part 471. The protruding part 472 may make close contact with the outer circumferential surface B of the cylindrical battery C so that the conductive member 47 may make close contact with the outer circumferential surface B of the cylindrical battery C.

The conductive member 47 may include a concave-convex part 473 that protrudes so as to be coupled to the outer circumferential surface plate 45. The concave-convex part 473 may be inserted into the outer circumferential surface plate 45. The conductive member 47 may be detachably attached to the outer circumferential surface plate 45 by the concave-convex part 473.

When the conductive member 47 is used for a long time to reach an end of its lifespan, an existing conductive member 47 may be removed from the outer circumferential surface plate 45 by the concave-convex part 473, and a new conductive member 47 may be attached to the outer circumferential surface plate 45 for use, so that replacement of the conductive member 47 may be facilitated.

Meanwhile, referring to FIG. 7, according to one embodiment of the present invention, the lift module 20 may include: a seating socket 21 on which a bottom surface of the cylindrical battery C is seated; a lift cylinder 22 provided on the main frame 10, coupled to the seating socket 21, and configured to lift and lower the seating socket 21 in a vertical direction; and a lift motor 23 coupled to the lift cylinder 22, and configured to lift and lower the lift cylinder 22 in the vertical direction.

The bottom surface of the cylindrical battery C may be seated on the seating socket 21. The seating socket 21 may be lifted and lowered in the vertical direction. The seating socket 21 may be lifted to receive the cylindrical battery C, and lowered to seat the cylindrical battery C thereon.

The seating socket 21 may be insulated. In this case, the seating socket 21 may be formed of an insulating material.

The lift cylinder 22 may be provided on the main frame 10. The lift cylinder 22 may be coupled to the seating socket 21. The lift cylinder 22 may be coupled to a lower portion of the seating socket 21.

The lift cylinder 22 may lift and lower the seating socket 21 in the vertical direction. The lift cylinder 22 may lift and lower the seating socket 21 so that the seating socket 21 may receive the cylindrical battery C. In addition, the lift cylinder 22 may lower the seating socket 21 to seat the cylindrical battery C on the seating socket 21 after the seating socket 21 receives the cylindrical battery C.

The lift motor 23 may be coupled to the lift cylinder 22. The lift motor 23 may lift and lower the lift cylinder 22. The lift motor 23 may lift and lower the lift cylinder 22 so that the lift cylinder 22 may lift and lower the seating socket 21.

Meanwhile, referring to FIG. 8, according to one embodiment of the present invention, the probe module 30 may include: a probe pin 33 making contact with the top surface A of the cylindrical battery C to apply the current to the top surface A of the cylindrical battery C; a horizontal moving unit 32 coupled to the probe pin 33, and configured to move the probe pin 33 in a horizontal direction; and a vertical moving unit 31 provided on the main frame 10, coupled to the horizontal moving unit 32, and configured to move the horizontal moving unit 32 in a vertical direction.

The probe pin 33 may move in the horizontal direction. In this case, the horizontal direction may be the X-axis and Y-axis directions. The probe pin 33 may move in the horizontal direction to the top surface A of the cylindrical battery C.

The probe pin 33 may make contact with the top surface A of the cylindrical battery C. The probe pin 33 may apply the current to the top surface A of the cylindrical battery C. The probe pin 33 may apply the current to the terminal part of the cylindrical battery C. Accordingly, the current may be conducted through the cylindrical battery C.

The horizontal moving unit 32 may be coupled to the probe pin 33. The horizontal moving unit 32 may move the probe pin 33 in the horizontal direction. In this case, the probe pin 33 may move to the top surface A of the cylindrical battery C.

The vertical moving unit 31 may be provided on the main frame 10. The vertical moving unit 31 may be coupled to the horizontal moving unit 32. The vertical moving unit 31 may move the horizontal moving unit 32 in the vertical direction. Accordingly, the probe pin 33 may move in the vertical direction and the horizontal direction to the top surface A of the cylindrical battery C.

In this case, according to one embodiment of the present invention, the horizontal moving unit 32 may include: a probe frame 323 configured to move in the horizontal direction, and having an end portion to which the probe pin 33 is coupled; a horizontal cylinder 322 coupled to the probe frame 323 to move the probe frame 323 in the horizontal direction; and a horizontal frame 321 to which the horizontal cylinder 322 is coupled, and having a lower portion to which the vertical moving unit 31 is coupled.

The probe frame 323 may form an exterior. The probe pin 33 may have the end portion to which the probe frame 323 is coupled.

The probe frame 323 may move in the horizontal direction. In this case, the probe frame 323 may move the probe pin 33 in the horizontal direction.

The horizontal cylinder 322 may be coupled to the probe frame 323. The horizontal cylinder 322 may move the probe frame 323 in the horizontal direction. Accordingly, the probe frame 323 may move in the horizontal direction, and the probe frame 323 may move the probe pin 33 in the horizontal direction.

The horizontal cylinder 322 may be coupled to the horizontal frame 321. The horizontal frame 321 may have the lower portion to which the vertical moving unit 31 is coupled. The horizontal frame 321 may be lifted and lowered in the vertical direction by the vertical moving unit 31.

In this case, according to one embodiment of the present invention, the vertical moving unit 31 may include: a vertical cylinder 312 coupled to the horizontal moving unit 32 to move the horizontal moving unit 32 in the vertical direction; and a vertical frame 311 coupled to the main frame 10, and to which the vertical cylinder 312 is coupled.

The vertical cylinder 312 may be coupled to the horizontal moving unit 32. The vertical cylinder 312 may be coupled to the horizontal frame 321.

The vertical cylinder 312 may move the horizontal moving unit 32 in the vertical direction. Accordingly, the horizontal moving unit 32 may move in the vertical direction.

The vertical frame 311 may be coupled to the main frame 10. The vertical cylinder 312 may be coupled to the vertical frame 311. The vertical frame 311 may support the vertical cylinder 312.

Accordingly, the vertical cylinder 312 may be supported by the vertical frame 311 to move the horizontal frame 321 in the vertical direction, and the horizontal cylinder 322 may move the probe frame 323 in the horizontal direction, so that the probe pin 33 coupled to the probe frame 323 may move in the vertical and horizontal directions to the top surface A of the cylindrical battery **C.**

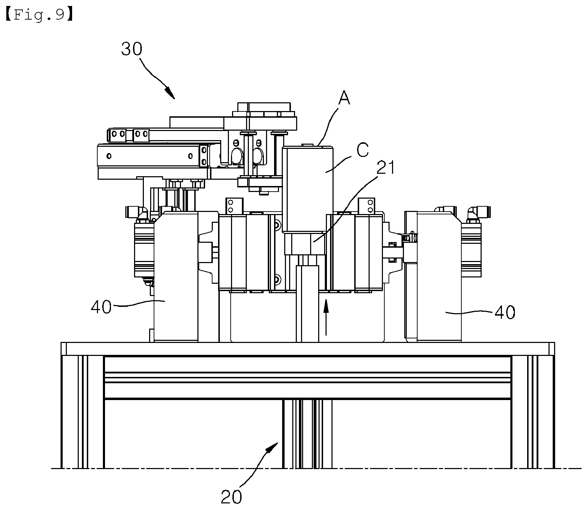

Hereinafter, an operation of the apparatus for inspecting the insulation of the cylindrical battery according to one embodiment of the present invention will be described with reference to FIGS. 9 to 11.

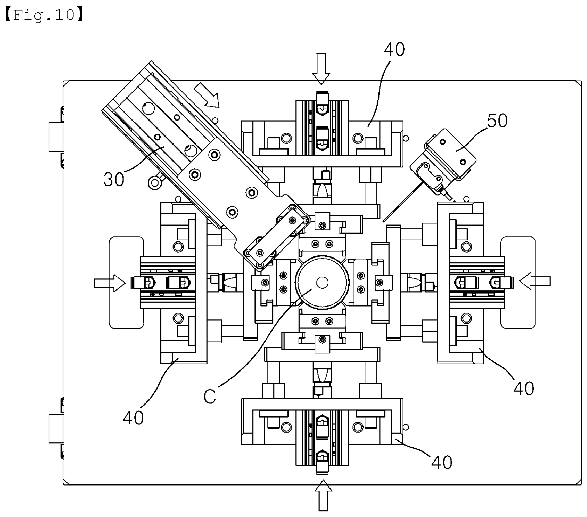

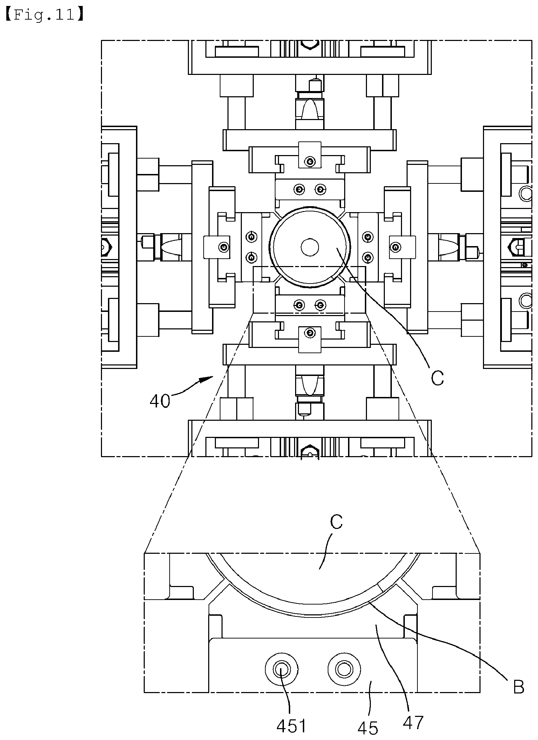

FIG. 9 is a view showing an operation of the lift module 20 according to one embodiment of the present invention, FIG. 10 is a view showing operations of the outer circumferential surface module 40 and the probe module 30 according to one embodiment of the present invention, and FIG. 11 is an enlarged view showing the conductive member 47 according to one embodiment of the present invention.

Referring to FIGS. 9 to 11, the cylindrical battery C having the outer circumferential surface B attached with the insulating tape may be transferred to the lift module 20. The cylindrical battery C may be seated on the lift module 20.

In this case, the lift motor 23 may lift the lift cylinder 22 so that the lift cylinder 22 may lift the seating socket 21. At this point, the bottom surface of the cylindrical battery C may be seated on the seating socket 21. The seating socket 21 may be lifted to receive the cylindrical battery C.

After the cylindrical battery C is received on the seating socket 21, the lift motor 23 may lower the lift cylinder 22 so that the lift cylinder 22 may lower the seating socket 21. Accordingly, the cylindrical battery C may be seated on the seating socket 21.

Thereafter, as shown in FIG. 10, the outer circumferential surface module 40 may move in the horizontal direction to make contact with the outer circumferential surface B of the cylindrical battery C, and the probe module 30 may move in the vertical and horizontal directions to make contact with the top surface A of the cylindrical battery C.

In this case, the vertical moving unit 31 may move the horizontal moving unit 32 in the vertical direction, and the horizontal moving unit 32 may move the probe pin 33 in the horizontal direction. Accordingly, the probe pin 33 may move to the top surface A of the cylindrical battery C by moving in the vertical direction and moving in the horizontal direction.

In addition, the outer circumferential surface bracket 42 may move forward toward the cylindrical battery C in the horizontal direction with respect to the outer circumferential surface frame 41. In this case, the outer circumferential surface moving unit 43 may move the outer circumferential surface bracket 42 forward.

Thereafter, as shown in FIG. 11, the outer circumferential surface bracket 42 may move the outer circumferential surface plate 45 forward. The outer circumferential surface plate 45 may move forward so that the conductive member 47 may make contact with the outer circumferential surface B of the cylindrical battery C. In this case, the outer circumferential surface B of the cylindrical battery C may make close contact with the seating part 471 of the conductive member 47.

Thereafter, the probe module 30 may apply the current to the cylindrical battery C. The probe pin 33 may apply the current to the terminal part of the cylindrical battery C. In this case, the insulating tape has to be attached to the outer circumferential surface B of the cylindrical battery C to insulate the current.

In some embodiments, when the outer circumferential surface B of the cylindrical battery C is insulated, the current may not be detected by the electric leakage detector coupled to the outer circumferential surface plate 45, so that the outer circumferential surface B of the cylindrical battery C may be determined as being normally insulated.

In some embodiments, the electric leakage may occur on the outer circumferential surface B due to a defect of the insulating tape, defective taping, or the like. In this case, the conductive member 47 may make contact with the outer circumferential surface B of the cylindrical battery C to allow the current, which is conducted through the outer circumferential surface B of the cylindrical battery C, to be conducted through the outer circumferential surface plate 45. At this point, the electric leakage detector coupled to the outer circumferential surface plate 45 may detect the electric leakage.

As described above, it will be understood by those of ordinary skill in the art to which the present invention pertains that the present invention can be embodied in other specific forms within the scope of the appended claims. Therefore, the embodiments described above are illustrative in all aspects, and should not be construed as limiting.

The scope of the present invention is determined by the appended claims rather than the detailed description, and should be construed as encompassing all changes or modifications derived from the scope of the claims.

## Claims

1. An apparatus for inspecting insulation of a cylindrical battery (C), the apparatus comprising:
a main frame (10) forming an exterior;
a lift module (20) provided on the main frame (10), and on which the cylindrical battery (C) having an outer circumferential surface (B) attached with an insulating tape is adapted to be seated;
a probe module (30) provided on the main frame (10), and
adapted to make contact with a top surface (A) of the cylindrical battery (C) to apply a current to the cylindrical battery (C); and
an outer circumferential surface module (40) provided on the main frame (10), adapted to make contact with the outer circumferential surface (B) of the cylindrical battery (C), and configured to detect a current conducted through the outer circumferential surface (B) of the cylindrical battery (C) when the probe module (30) applies the current to the cylindrical battery (C),
wherein the outer circumferential surface module (40) includes:
an outer circumferential surface frame (41) fixed to the main frame (10);
an outer circumferential surface bracket (42) configured to move forward and rearward with respect to the outer circumferential surface frame (41);
an outer circumferential surface moving unit (43) provided on the outer circumferential surface frame (41), and configured to move the outer circumferential surface bracket (42) forward and rearward;
an outer circumferential surface guide (44) provided on the outer circumferential surface frame (41), and configured to guide the outer circumferential surface bracket (42) when the outer circumferential surface bracket (42) moves forward and rearward;
an outer circumferential surface plate (45) to which an electric leakage detector for detecting an electric leakage is coupled;
an insulating resin (46) provided between the outer circumferential surface bracket (42) and the outer circumferential surface plate (45) to insulate the outer circumferential surface bracket (42) from the outer circumferential surface plate (45); and
a conductive member (47) coupled to the outer circumferential surface plate (45), and adapted to make contact with the outer circumferential surface (B) of the cylindrical battery (C),
**characterized in that** the conductive member (47) includes a concave-convex part (473) that protrudes so as to be coupled to the outer circumferential surface plate (45), and
the conductive member (47) adapted to be detachably attached to the outer circumferential surface plate (45) by the concave-convex part (473).

2. The apparatus of claim 1, wherein the conductive member (47) allows the current, which is conducted through the outer circumferential surface (B) of the cylindrical battery (C), to be conducted through the outer circumferential surface plate (45).

3. The apparatus of claim 1, wherein the conductive member (47) includes a seating part (471) that is curved to correspond to the outer circumferential surface (B) of the cylindrical battery (C).

4. The apparatus of claim 1, wherein the conductive member (47) is formed of an elastic material.

5. The apparatus of claim 1, wherein the outer circumferential surface modules (40) are provided in multiple numbers, and each outer circumferential surface module (40) is arranged to contact a different area of the outer circumferential surface (B) of the cylindrical battery (C), and the outer circumferential surface (B) of the cylindrical battery (C) is wrapped by a plurality of the outer circumferential surface modules (40).

6. The apparatus of claim 1, wherein the lift module (20) includes:
a seating socket (21) on which a bottom surface of the cylindrical battery (C) is seated;
a lift cylinder (22) provided on the main frame (10), coupled to the seating socket (21), and configured to lift and lower the seating socket (21) in a vertical direction; and
a lift motor (23) coupled to the lift cylinder (22), and configured to lift and lower the lift cylinder (22) in the vertical direction.

7. The apparatus of claim 1, wherein the probe module (30) includes:
a probe pin (33) making contact with the top surface (A) of the cylindrical battery (C) to apply the current to the top surface (A) of the cylindrical battery (C);
a horizontal moving unit (32) coupled to the probe pin (33), and configured to move the probe pin (33) in a horizontal direction; and
a vertical moving unit (31) provided on the main frame (10), coupled to the horizontal moving unit (32), and configured to move the horizontal moving unit (32) in a vertical direction.

8. The apparatus of claim 7, wherein the horizontal moving unit (32) includes:
a probe frame (323) configured to move in the horizontal direction, and having an end portion to which the probe pin (33) is coupled;
a horizontal cylinder (322) coupled to the probe frame (323) to move the probe frame (323) in the horizontal direction; and
a horizontal frame (321) to which the horizontal cylinder (322) is coupled, and having a lower portion to which the vertical moving unit (31) is coupled.

9. The apparatus of claim 7, wherein the vertical moving unit (31) includes:
a vertical cylinder (312) coupled to the horizontal moving unit (32) to move the horizontal moving unit (32) in the vertical direction; and
a vertical frame (311) coupled to the main frame (10), and to which the vertical cylinder (312) is coupled.

## Patentansprüche

1. Vorrichtung zur Inspektion der Isolierung einer zylindrischen Batterie (C), wobei die Vorrichtung umfasst:
einen Hauptrahmen (10), der ein Äußeres bildet;
ein Hebemodul (20), das auf dem Hauptrahmen (10) vorgesehen ist und auf dem die zylindrische Batterie (C), die eine mit einem Isolierband befestigte äußere Umfangsfläche (B) aufweist, aufgesetzt werden kann;
ein Sondenmodul (30), das auf dem Hauptrahmen (10) vorgesehen ist und so angepasst ist, dass es mit einer oberen Fläche (A) der zylindrischen Batterie (C) in Kontakt kommt, um einen Strom an die zylindrische Batterie (C) anzulegen; und
ein Außenumfangsflächenmodul (40), das auf dem Hauptrahmen (10) vorgesehen ist, das dazu angepasst ist, einen Kontakt mit der äußeren Umfangsfläche (B) der zylindrischen Batterie (C) herzustellen, und das dazu konfiguriert ist, einen Strom zu erfassen, der durch die äußere Umfangsfläche (B) der zylindrischen Batterie (C) geleitet wird, wenn das Sondenmodul (30) Strom an die zylindrische Batterie (C) anlegt, wobei das Außenumfangsflächenmodul (40) Folgendes umfasst:
einen Außenumfangsflächenrahmen (41), der an dem Hauptrahmen (10) befestigt ist;
eine Außenumfangsflächenhalterung (42), die so konfiguriert ist, dass sie sich in Bezug auf den Außenumfangsflächenrahmen (41) vorwärts und rückwärts bewegt;
eine Außenumfangsflächenbewegungseinheit (43), die an dem Außenumfangsflächenrahmen (41) vorgesehen und so konfiguriert ist, dass sie die Außenumfangsflächenhalterung (42) nach vorne und nach hinten bewegt;
eine Außenumfangsflächenführung (44), die an dem Außenumfangsflächenrahmen (41) vorgesehen ist und so konfiguriert ist, die Außenumfangsflächenhalterung (42) zu führen, wenn sich die Außenumfangsflächenhalterung (42) nach vorne und nach hinten bewegt;
eine Außenumfangsflächenplatte (45), mit der ein elektrischer Leckagedetektor zum Erfassen eines elektrischen Lecks gekoppelt ist;
ein isolierendes Harz (46), das zwischen der Außenumfangsflächenhalterung (42) und der Außenumfangsflächenplatte (45) vorgesehen ist, um die Außenumfangsflächenhalterung (42) gegenüber der Außenumfangsflächenplatte (45) zu isolieren; und
ein leitendes Element (47), das mit der Außenumfangsflächenplatte (45) gekoppelt und dazu geeignet ist, die äußere Umfangsfläche (B) der zylindrischen Batterie (C) zu berühren,
**dadurch gekennzeichnet, dass** das leitende Element (47) einen konkav-konvexen Teil (473) aufweist, der so vorsteht, dass er mit der Außenumfangsflächenplatte (45) gekoppelt ist, und
dass das leitende Element (47) so beschaffen ist, dass es durch den konkav-konvexen Teil (473 ) abnehmbar an der Außenumfangsflächenplatte (45) befestigbar ist.

2. Vorrichtung nach Anspruch 1, wobei das leitende Element (47) ermöglicht, dass der Strom, der durch die äußere Umfangsfläche (B) der zylindrischen Batterie (C) geleitet wird, durch die Außenumfangsflächenplatte (45) geleitet wird.

3. Vorrichtung nach Anspruch 1, wobei das leitende Element (47) einen Sitzteil (471) aufweist, der gekrümmt ist, um der äußeren Umfangsfläche (B) der zylindrischen Batterie (C) zu entsprechen.

4. Vorrichtung nach Anspruch 1, wobei das leitende Element (47) aus einem elastischen Material gebildet ist.

5. Vorrichtung nach Anspruch 1, wobei die Außenumfangsflächenmodule (40) in mehrfacher Anzahl vorgesehen sind und jedes Außenumfangsflächenmodul (40) so angeordnet ist, dass es einen anderen Bereich der äußeren Umfangsfläche (B) der zylindrischen Batterie (C) berührt, und wobei die äußere Umfangsfläche (B) der zylindrischen Batterie (C) von mehreren Außenumfangsflächenmodulen (40) umhüllt ist.

6. Vorrichtung nach Anspruch 1, wobei das Hebemodul (20) Folgendes umfasst:
einen Sitzsockel (21), auf dem eine Bodenfläche der zylindrischen Batterie (C) sitzt;
einen Hubzylinder (22), der auf dem Hauptrahmen (10) vorgesehen ist, mit dem Sitzsockel (21) gekoppelt und so konfiguriert ist, dass er den Sitzsockel (21) in vertikaler Richtung anhebt und absenkt; und
einen Hubmotor (23), der mit dem Hubzylinder (22) gekoppelt und so konfiguriert ist, dass er den Hubzylinder (22) in der vertikalen Richtung anhebt und absenkt.

7. Vorrichtung nach Anspruch 1, wobei das Sondenmodul (30) Folgendes umfasst
einen Sondenstift (33), der mit der Oberseite (A) der zylindrischen Batterie (C) in Kontakt steht, um Strom an die Oberseite (A) der zylindrischen Batterie (C) anzulegen;
eine horizontale Bewegungseinheit (32), die mit dem Sondenstift (33) gekoppelt und dazu konfiguriert ist, den Sondenstift (33) in horizontaler Richtung zu bewegen; und
eine vertikale Bewegungseinheit (31), die an dem Hauptrahmen (10) vorgesehen ist, mit der horizontalen Bewegungseinheit (32) gekoppelt und dazu konfiguriert ist, die horizontale Bewegungseinheit (32) in vertikaler Richtung zu bewegen.

8. Vorrichtung nach Anspruch 7, wobei die horizontale Bewegungseinheit (32) Folgendes umfasst:
einen Sondenrahmen (323), der dazu konfiguriert ist, sich in horizontaler Richtung zu bewegen und der einen Endabschnitt aufweist, an den der Sondenstift (33) gekoppelt ist;
einen horizontalen Zylinder (322), der mit dem Sondenrahmen (323) gekoppelt ist, um den Sondenrahmen (323) in horizontalen Richtung zu bewegen; und
einen horizontalen Rahmen (321), mit dem der horizontale Zylinder (322) gekoppelt ist und der einen unteren Abschnitt aufweist, mit dem die vertikale Bewegungseinheit (31) gekoppelt ist.

9. Vorrichtung nach Anspruch 7, wobei die vertikale Bewegungseinheit (31) Folgendes umfasst:
einen vertikalen Zylinder (312), der mit der horizontalen Bewegungseinheit (32) gekoppelt ist, um die horizontale Bewegungseinheit (32) in vertikaler Richtung zu bewegen; und
einen vertikalen Rahmen (311), der mit dem Hauptrahmen (10) gekoppelt ist und mit dem der vertikale Zylinder (312) gekoppelt ist.

## Revendications

1. Appareil d'inspection d'isolation d'une batterie cylindrique (C), l'appareil comprenant :
un cadre principal (10) formant un extérieur ;
un module de levage (20) ménagé sur le cadre principal (10) et sur lequel la batterie cylindrique (C) ayant une surface circonférentielle extérieure (B) fixée avec une bande isolante est conçue pour être placée ;
un module de sonde (30) ménagé sur le cadre principal (10) et conçu pour entrer en contact avec une surface supérieure (A) de la batterie cylindrique (C) afin d'appliquer un courant sur la batterie cylindrique (C) ; et
un module de surface circonférentielle extérieure (40) ménagé sur le cadre principal (10), conçu pour établir un contact avec la surface circonférentielle extérieure (B) de la batterie cylindrique (C), et configuré pour détecter un courant conduit à travers la surface circonférentielle extérieure (B) de la batterie cylindrique (C) lorsque le module de sonde (30) applique le courant sur la batterie cylindrique (C),
en ce que le module de surface circonférentielle extérieure (40) comprend :
un cadre de surface circonférentielle extérieure (41) fixé au cadre principal (10) ;
un support de surface circonférentielle extérieure (42) configuré pour se déplacer vers l'avant et vers l'arrière par rapport au cadre de surface circonférentielle extérieure (41) ;
une unité de déplacement de surface circonférentielle extérieure (43) ménagée sur le cadre de surface circonférentielle extérieure (41) et configurée pour déplacer le support de surface circonférentielle extérieure (42) vers l'avant et vers l'arrière ;
un guide de surface circonférentielle extérieure (44) ménagé sur le cadre de surface circonférentielle extérieure (41) et configuré pour guider le support de surface circonférentielle extérieure (42) lorsque le support de surface circonférentielle extérieure (42) se déplace vers l'avant et vers l'arrière ;
une plaque de surface circonférentielle extérieure (45) à laquelle est couplé un détecteur de fuite électrique pour détecter une fuite électrique ;
une résine isolante (46) prévue entre le support de surface circonférentielle extérieure (42) et la plaque de surface circonférentielle extérieure (45) pour isoler le support de surface circonférentielle extérieure (42) de la plaque de surface circonférentielle extérieure (45) ; et
un élément conducteur (47) couplé à la plaque de surface circonférentielle extérieure (45), et conçu pour établir un contact avec la surface circonférentielle extérieure (B) de la batterie cylindrique (C),
**caractérisé en ce que** l'élément conducteur (47) comprend une partie concave-convexe (473) qui fait saillie de manière à être couplée à la plaque de surface circonférentielle extérieure (45), et l'élément conducteur (47) est adapté pour être fixé de manière amovible à la plaque de surface circonférentielle extérieure (45) par la partie concave-convexe (473).

2. Appareil selon la revendication 1, en ce que l'élément conducteur (47) permet au courant qui est conduit à travers la surface circonférentielle extérieure (B) de la batterie cylindrique (C) d'être conduit à travers la plaque de surface circonférentielle extérieure (45).

3. Appareil selon la revendication 1, en ce que l'élément conducteur (47) comprend une partie d'appui (471) qui est courbée pour correspondre à la surface circonférentielle extérieure (B) de la batterie cylindrique (C).

4. Appareil selon la revendication 1, en ce que l'élément conducteur (47) est réalisé en un matériau élastique.

5. Appareil selon la revendication 1, en ce que les modules de surface circonférentielle extérieure (40) sont prévus en plusieurs exemplaires, et chaque module de surface circonférentielle extérieure (40) est disposé pour entrer en contact avec une zone différente de la surface circonférentielle extérieure (B) de la batterie cylindrique (C), et la surface circonférentielle extérieure (B) de la batterie cylindrique (C) est entourée par une pluralité de modules de surface circonférentielle extérieure (40).

6. Appareil selon la revendication 1, en ce que le module de levage (20) comprend :
un support d'assise (21) sur lequel repose une surface inférieure de la batterie cylindrique (C) ;
un vérin de levage (22) ménagé sur le cadre principal (10), couplé au support d'assise (21) et configuré pour lever et abaisser le support d'assise (21) dans un sens vertical ; et
un moteur de levage (23) couplé au vérin de levage (22), et configuré pour lever et abaisser le vérin de levage (22) dans le sens vertical.

7. Appareil selon la revendication 1, en ce que le module de sonde (30) comprend :
une broche de sonde (33) établissant le contact avec la surface supérieure (A) de la batterie cylindrique (C) afin d'appliquer le courant à la surface supérieure (A) de la batterie cylindrique (C) ;
une unité de déplacement horizontal (32) couplée à la broche de sonde (33), et configurée pour déplacer la broche de sonde (33) dans un sens horizontal ; et
une unité de déplacement vertical (31) ménagée sur le cadre principal (10), couplée à l'unité de déplacement horizontal (32), et configurée pour déplacer l'unité de déplacement horizontal (32) dans un sens vertical.

8. Appareil selon la revendication 7, en ce que l'unité de déplacement horizontal (32) comprend :
un cadre de sonde (323) configuré pour se déplacer dans le sens horizontal et ayant une partie d'extrémité à laquelle la broche de sonde (33) est couplée ;
un cylindre horizontal (322) couplé au cadre de sonde (323) pour déplacer le cadre de sonde (323) dans le sens horizontal ; et
un cadre horizontal (321) auquel le cylindre horizontal (322) est couplé et ayant une partie inférieure à laquelle l'unité de déplacement vertical (31) est couplée.

9. Appareil selon la revendication 7, en ce que l'unité de déplacement vertical (31) comprend :
un cylindre vertical (312) couplé à l'unité de déplacement horizontal (32) pour déplacer l'unité de déplacement horizontal (32) dans le sens vertical ; et
un cadre vertical (311) couplé au cadre principal (10), et auquel le cylindre vertical (312) est couplé.
